# EUROPEAN PATENT SPECIFICATION

(11) **EP 1 677 343 B1**
(45) Date of publication and mention of the grant of the patent: **14.11.2012**
(21) Application number: 04787789.9
(22) Date of filing: 09.09.2004
(51) Int. Cl.: H01L 21/312, H01L 21/3065, C08G 77/52, C09D 183/14

(54) **COMPOSITION FOR FORMING ETCHING STOPPER LAYER**
ZUSAMMENSETZUNG ZUR BILDUNG EINER ÄTZSTOPFSCHICHT
COMPOSITION PERMETTANT DE FORMER UNE COUCHE D'ARRET DE GRAVURE

(30) Priority: 10.10.2003 JP 2003352219
(43) Date of publication of application: 05.07.2006
(73) Proprietor: AZ Electronic Materials USA Corp., Somerville, NJ 08876 (US)
(72) Inventor: TASHIRO, Yuji, AZ Electronic Materials (Japan) K.K, Ogasa-gun, Shizuoka 437-1412 (JP); AOKI, Hiroyuki, AZ Elect. Materials (Japan) K.K., Bunkyo-ku, Tokyo 113-0021 (JP); ISHIKAWA, Tomonori, AZ Elect Materials (Japan) K.K, Bunkyo-ku, Tokyo 113-0021 (JP)
(74) Representative: Isenbruck, Günter
(86) International application number: PCT/JP2004/013125
(87) International publication number: WO 2005/036630

(56) References cited:
- JP-A- 06 151 612
- JP-A- 57 117 531
- JP-A- 2002 293 941
- JP-B2- 06 097 567
- US-A- 3 287 310
- US-A- 3 325 530
- US-A- 5 141 817
- US-A- 5 565 529

## Description

The present invention relates to a production process of a semiconductor device. More particularly, the present invention relates to a production process of a semiconductor device using a composition for formation of etching stopper layer for use in the formation of an etching stopper layer in the production of a semiconductor device by a damascene method.

### BACKGROUND ART

In recent years, there are ever-increasing needs of integration in semiconductor devices, and the trend of the design rule is a steadily increasing integration density. This trend has led to a more complicated semiconductor device structure and, at the same time, a demand for an enhanced operating speed and reduced power consumption. To meet such needs, the adoption of a semiconductor device production process using a damascene method instead of the conventional semiconductor device production process has been proposed. In the damascene method, since copper can be used instead of aluminum used in the conventional wiring material, an enhanced operating speed and reduced power consumption of the semiconductor device can be realized.

The damascene method is a method for manufacturing a semiconductor device which comprises forming trenches or vias for wiring by etching or the like in an insulating film provided on a substrate and filling a wiring material such as copper into the trenches or vias. Damascene methods may be classified into a single damascene method and a dual damascene method according to the structure to be formed, or may be classified into a trench first method and a via first method according to which of the trench and the via is formed first. In any method, since vias or trenches are formed to a given depth by etching, an etching stopper layer is provided for the restriction of the depth.

An example of pattern formation using the damascene method will be described with reference to the accompanying drawings.

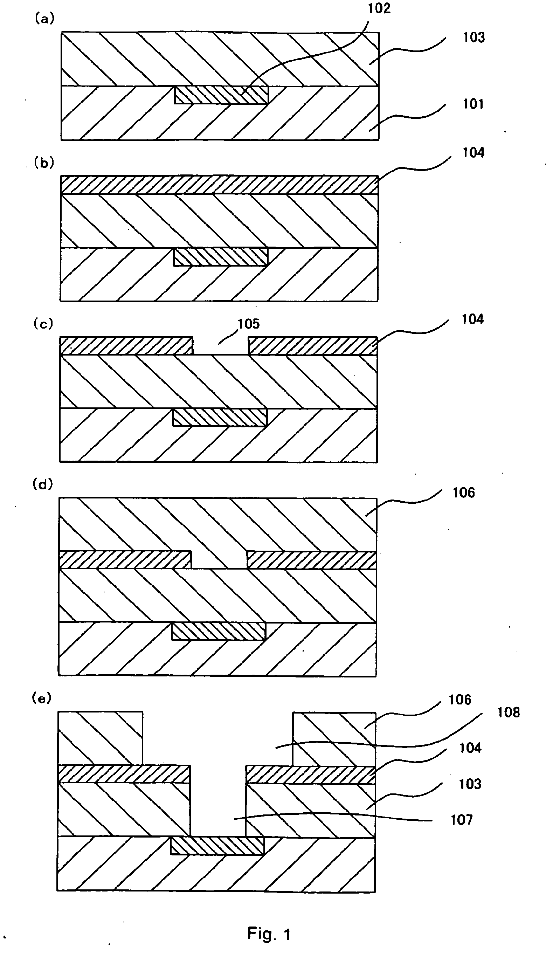

As shown in Fig. 1(a), an insulating film 101 is formed on a substrate (not shown) such as silicon. A wiring element 102 is formed on this insulating film, and an insulating film 103 is formed so as to cover the wiring element 102. Subsequently, an etching stopper layer 104 is formed on the insulating film 103 (Fig. 1(b)). An opening 105 as a connection hole is then formed in the etching stopper layer, for example, by lithography (Fig. 1(c)). Further, an insulating layer 106 is formed thereon (Fig. 1(d)), and a via 107 and a trench 108 are then formed by dry etching (Fig. 1(e)). In this case, the insulating layer 106 located on the surface of the assembly is removed by etching. However, the etching rate of the etching stopper layer is so low that the underlying insulating layer 103 is not removed. The insulating layer 103 only in its part underlying the opening 105 is removed to form a via 107. The internal wall of the via and trench thus formed is if necessary covered with a barrier metal layer, a wiring material such as copper is then filled into the via and the trench, and the surface is polished by chemical mechanical polishing to form a plug (dual damascene method).

In this example, only one etching stopper layer is used. If necessary, however, after the insulating layer 106 is formed, one more etching stopper layer may be formed thereon.

Regarding an insulting material used in the production of a semiconductor element by the damascene method, in order to lower the permittivity of the semiconductor element, for example, organic materials and fluorosilicate glass have hitherto been used as a main material for constituting the element. The material used in the etching stopper layer, however, should have a relatively higher level of etching resistance than these insulating materials. That is, the ratio of the rate of etching of the insulating material to the rate of etching of the etching stopper layer (known as selectivity) should be large. Despite such demands, the above organic materials and the like do not have satisfactory etching resistance and thus do not provide a satisfactory selectivity. Therefore, high-permittivity oxide films and nitride films such as silicon oxide and silicon nitride films have hitherto been used as a material for formation of etching stopper layer (for example, patent document 1 or patent document 2). Therefore, in the conventional semiconductor element, lowering in permittivity of the whole element was difficult.

Accordingly, a proposal has been made on a method in which the permittivity of the whole semiconductor device is lowered by improving the structure of the semiconductor element (patent document 3). This method, however, the production process per se should be changed, and the conventional production process as such cannot be used without difficulties.
Patent document 1: Japanese Patent Laid-Open Publication No. 102359/2001
Patent document 2: Japanese Patent Laid-Open Publication No. 15295/2003
Patent document 3: Japanese Patent Laid-Open Publication No. 349151/2000
US 5, 565,529 and US 5,141,817 disclose an etching layer composition containing a specific polysiloxane copolymer comprising a disilylbenzene structure.

### DISCLOSURE OF THE INVENTION

### PROBLEMS TO BE SOLVED BY THE INVENTION

Thus, any etching stopper layer, which can simultaneously realize high dry etching resistance and low permittivity, has not hitherto been known, and, in order to lower the permittivity of the whole semiconductor device, the development of an etching stopper layer having high dry etching resistance and low permittivity, or a composition for the formation of the etching stopper layer has been desired.

### MEANS FOR SOLVING THE PROBLEMS

According to the present invention, there is provided a process for producing a semiconductor device, comprising the steps of: forming an insulating layer and an etching stopper layer on a substrate; removing part of the insulating layer by dry etching; and filling an electrically conductive material into a groove or hole thus formed, wherein said etching stopper layer is formed by curing a composition comprising a silicon-containing polymer, wherein 5% to 100% by mole, based on the total number of moles of silicon contained in the silicon-containing polymer in the composition, of silicon is contained in a disilylbenzene structure, and wherein the silicon containing polymer containing a disilylbenzene structure is a silazane polymer or a siloxazane polymer.

### EFFECT OF THE INVENTION

The present invention provides a process comprising the formation of an etching stopper layer to which a damascene method and the like are applicable and which has low permittivity and has high dry etching resistance under conditions for interlayer insulating film etching.

For the etching stopper layer formed using the composition according to the present invention, the selectivity relative to various materials can be varied by varying the etching gas used in etching. Specifically, when etching of the etching stopper layer per se is contemplated, the selectivity relative to conventional hard mask materials such as SiO₂ and SiN can be increased by properly selecting the etching gas. Alternatively, a method may be adopted in which the selectivity relative to a material for the insulating layer, for example, methylsilsesquioxane, can be rendered close to 1 by selecting a different etching gas and the etching stopper layer and the insulating layer are simultaneously etched at the same etching rate. That is, the etching stopper layer formed using the process according to the present invention can be utilized as an etching stopper layer and, at the same time, can properly meet various requirements depending upon various semiconductor device production conditions.

### BRIEF DESCRIPTION OF THE DRAWING

[Fig. 1] Fig. 1 is a cross-sectional view illustrating a production process of a semiconductor device by a damascene method.

### DESCRIPTION OF REFERENCE CHARACTERS

101 insulating film
102 wiring element
103 insulating film
104 etching stopper layer
105 opening
106 insulating film
107 via
108 trench

### BEST MODE FOR CARRYING OUT THE INVENTION

In the present invention, a composition for formation of etching stopper layer comprises a silicon-containing polymer having a disilylbenzene ring. The disilylbenzene structure is a structure comprising two silicon atoms attached to a benzene structure. A compound or polymer having this structure is sometimes called "silylbenzene."

The benzene ring constituting the disilylbenzene structure in the invention of the present application may be part of a binuclear aromatic ring. A preferred disilylbenzene structure is structure (I) represented by formula 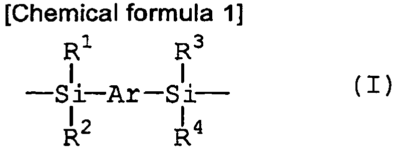 wherein R¹ to R⁴ each independently are selected from a group consisting of hydrogen, an alkyl group, preferably a C₁ to C₃ alkyl group, an alkenyl group, preferably a C₂ to C₄ alkenyl group, a cycloalkyl group, preferably a C₇ or C₈ cycloalkyl group, an aryl group, preferably a C₆ to C₁₀ aryl group, an aralkyl group, preferably a C₇ to C₁₁ aralkyl group, an alkylamino group, preferably a C₁ to C₃ alkylamino group, and an alkylsilyl group, preferably a C₁ to C₃ alkylsilyl group; and Ar represents an aryl group, preferably a phenylene group.

In the present invention, a more preferred disilylbenzene structure is structure (II) represented by formula 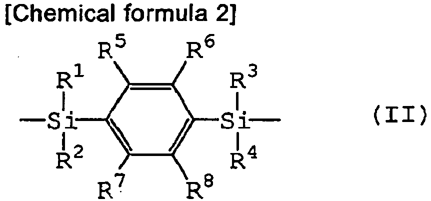 wherein R¹ to R⁴ are as defined in formula (I); and R⁵ to R⁸ are selected from a group consisting of hydrogen, a C₁ to C₃ alkyl group, a halogen atom, a C₁ to C₃ alkoxide group, and a C₁ to C₃ amino group.

The silicon-containing polymers, are silazane polymers or siloxazane polymers having a disilylbenzene structure.

The above silicon-containing polymer may be produced by polymerizing any desired monomer which can form a disilylbenzene structure in the polymer structure. An example of a silicon-containing polymer production method is to polymerize a monomer having a disilylbenzene structure. Such monomers are preferably monomers represented by formula (Ia) or more preferably monomers represented by formula (IIa): 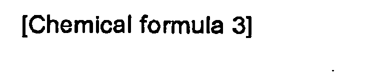 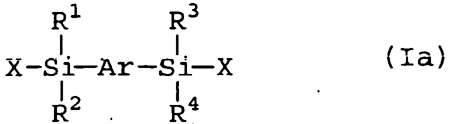 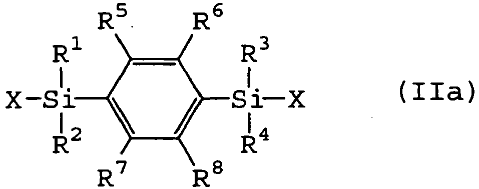 wherein R¹ to R⁸ are as defined in formula (II); and X's, which may be the same or different, represent a halogen atom or a hydroxyl group.

Such monomers include 1,4-bis(dimethylchlorosilyl) benzene, 1,4-bis(hydroxydimethylchlorosilyl)benzene, and 1,4-bis(diethylchlorosilyl)benzene.

When the silicon-containing polymer used in the present invention is synthesized, two or more monomers described above may be mixed for polymerization.

The monomer may be produced by any desired method. Specifically, the monomer may be produced, for example, by
(A) a Grignard reaction between a dihalogenated silane and an aromatic Grignard reagent, or
(B) a decarbonylation reaction between a diacyl aromatic compound and a dihalogenated silane.

The composition according to the present invention indispensably contains the above silicon-containing polymer having a disilylbenzene structure. When the etching stopper layer is formed using the composition according to the present invention, in order to improve the processability of the etching stopper layer per se, the content of carbon in the silicon-containing polymer is preferably high. That is, the etching selectivity relative to an inorganic material used in a hard mask such as SiO₂ can be further increased by increasing the content of carbon in the silicon-containing polymer. To this end, the presence of an aromatic group rather than an aliphatic hydrocarbon group as the monomer is preferred. The presence of a phenyl group is more preferred. Specifically, the silicon-containing polymer preferably has an aromatic group-containing structure in addition to the disilylbenzene structure. The content of carbon specifically varies, for example, upon properties required of the contemplated etching stopper layer and etching conditions. In general, however, the carbon content is preferably not less than 30% by weight, more preferably not less than 55% by weight.

Further, the silicon-containing polymer used in the present invention may also be formed by using a combination of the above monomer having a disilylbenzene structure with other monomer. In particular, when the monomer having a disilylbenzene structure is less likely to undergo homopolymerization, the polymerization of a monomer for linking the above monomer is effective. In this case, a polymer having a satisfactory degree of polymerization can be formed by copolymerizing a bifunctional or trifunctional monomer with the monomer having a disilylbenzene structure. The bifunctional or trifunctional monomer may be any desired one so far as it is polymerizable with the monomer having a disilylbenzene structure and does not sacrifice the effect of the present invention. Specific examples of such monomers include halogenated silanes such as phenyltrichlorosilane, diphenyldichlorosilane, methyltrichlorosilane, and methylhydrodichlorosilane.

The silicon-containing polymer used in the present invention has a disilylbenzene structure, and the amount of the disilylbenzene structure should be larger than a given amount. Specifically, 5% to 100% by mole, preferably 20% to 60% by mole, based on the total number of moles of silicon contained in the silicon-containing polymer in the composition according to the present invention, of silicon should be contained in the disilylbenzene structure in the silicon-containing polymer.

The number average molecular weight of the silicon-containing polymer contained in the composition according to the present invention is preferably not less than 700, more preferably not less than 1000, from the viewpoint of maintaining film forming properties and is preferably not more than 100,000, more preferably not more than 10,000, from the viewpoint of maintaining the composition in a viscosity range suitable for handling.

Preferably not less than 10% by mole, more preferably not less than 30% by mole, of the monomers constituting the silicon-containing polymer is accounted for by the monomer having a disilylbenzene structure, although the content also varies depending upon, according to the present invention, the components contained in the composition, the mixing ratio of the components, and the type of monomers constituting the silicon-containing polymer.

When the above requirements are satisfied, the composition may contain a polymer other than the above polymer having a disilylbenzene structure.

The composition for formation of etching stopper layer according to the present invention may contain a solvent and other additives in addition to the above polymer.

The composition according to the present invention generally contains a solvent in addition to the above polymer. A solvent which can homogeneously dissolve or disperse the above polymer is selected as this solvent. The polymer is selected from aromatic hydrocarbons, aliphatic hydrocarbons and the like. Preferred are xylene, toluene, propylene glycol monomethyl ether acetate, cyclohexane and the like.

The composition for formation of etching stopper layer according to the present invention may if necessary contain other additives. Such additives include crosslinking agents, specifically tetraethoxysilane, tetramethoxysilane and the like.

Upon heating, the composition for formation of etching stopper layer according to the present invention is cured and consequently is converted to a silicon-containing material suitable for formation of etching stopper layer. In general, the composition is coated onto a base material or the like, and the coating is heated on a hot plate or in a heating oven. In this case, the heating temperature is generally 250 to 500°C, preferably 350 to 450°C, and the heating time is generally 10 to 60 min, preferably 30 to 50 min. Heating conditions may vary depending upon the formulation of the composition and the type of the silicon-containing monomer.

In the cured silicon-containing material prepared by heating the above composition, in general, the polymer structure before curing remains substantially unchanged. Accordingly, 5% to 100% by mole, based on the total number of moles of silicon contained in the cured silicon-containing material, of silicon is contained in the disilylbenzene structure. This silicon-containing material is characterized by high dry etching resistance and low permittivity. In particular, the specific permittivity is lower than that of materials used in the etching stopper layer in the prior art (about 8) and is generally not more than 3.5, particularly 2.8 to 3.2 and thus greatly contributes to a reduction in permittivity of semiconductor devices. Therefore, the etching stopper layer according to the present invention is a material that is very useful as an etching stopper layer in semiconductor devices.

The composition for formation of etching stopper layer according to the present invention is used for formation of etching stopper layer in a semiconductor device production process, particularly a damascene method. The semiconductor device production process using the composition for formation of etching stopper layer comprises the steps of: forming an insulating layer and an etching stopper layer on a substrate; removing part of the insulating layer by dry etching to form a groove or a hole; and filling an electrically conductive material into the groove or hole. In this case, the etching stopper layer is formed using the composition for formation of etching stopper layer.

In this production process, steps other than the step of forming the etching stopper layer may be carried out by using a combination of any conventional methods. The production process of a semiconductor device according to the present invention is characterized by the step of forming an etching stopper layer using a composition containing a silicon-containing polymer having a disilylbenzene structure.

The method for formation of etching stopper layer comprises coating the above composition for formation of etching stopper layer onto a surface of a substrate or an insulating layer or the like provided on the substrate and curing the coating.

The composition for formation of etching stopper layer may be coated by any method, for example, spin coating, dip coating, or curtain coating. Spin coating is preferred.

The composition coated onto the substrate is if necessary baked to remove excess solvent and is then heated for curing. The baking is carried out at a temperature of about 100 to 250°C for about 1 to 5 min depending upon the solvent. Even when baking is carried out, heating conditions for curing are the same as those described above.

Thus, the etching stopper layer formed using the composition for formation of etching stopper layer according to the present invention can realize excellent dry etching resistance and low permittivity. For example, the etching stopper layer has dry etching resistance favorably comparable with silicon nitride or silicon oxide used as an etching stopper layer in the prior art. Further, regarding the permittivity, it should be noted that the specific permittivity of the conventional silicon nitride is about 8, whereas the specific permittivity of the etching stopper layer formed using the composition for formation of etching stopper layer according to the present invention is about 3, demonstrating that the etching stopper layer formed using the composition for formation of etching stopper layer according to the present invention can realize a much lower permittivity than the conventional etching stopper layer.

### Comparative Synthesis Example 1

The air in a 1-liter reaction vessel installed within a thermostatic chamber kept at a temperature of -5°C was replaced by dry nitrogen. Dry pyridine (400 ml) was then placed in the reaction vessel. The reaction vessel was held until dry pyridine reached a constant temperature. Thereafter, phenyltrichlorosilane (PhSiCl3) (105.75 g) was gradually added with stirring.

Next, after confirming that the contents of the reaction vessel reached a constant temperature, 400 ml of hydrous pyridine containing 4.5 g of distilled water was gradually added over a period of about 30 min. At that time, a temperature rise was observed. After the completion of the reaction, when the reaction mixture reached a predetermined temperature, ammonia gas was blown into the reaction mixture.

After the completion of the reaction, the reaction mixture was stirred for about one hr and was then filtered under pressure in a nitrogen atmosphere to give 750 ml of a filtrate.

Dry xylene (about 1000 ml) was added to this filtrate, and the solvent was removed under the reduced pressure to give 63 g of a solid polymer. The number average molecular weight of this polymer was measured by GPC and was found to be 900. The weight average molecular weight was 2600. This polymer was measured by FT-IR. As a result, absorption attributable to NH group was observed at wavenumber 3366 cm⁻¹; absorption attributable to C-H in a benzene ring was observed at wavenumber around 3000 cm⁻¹; absorption attributable to Si-O-Si was observed at wavenumber around 1020 cm⁻¹; and absorption attributable to Si-Ph was observed at wavenumber around 1400 cm⁻¹.

Further, the results of ²⁹Si-NMR analysis using a tetramethylsilane standard show that a signal of PhSiN₃ is observed at -31 ppm, a signal of PhSiN₂O is observed at -40 to -50 ppm, a signal of PhSiNO₂ is observed at -55 to -65 ppm, and a signal of PhSiO₃ is observed at -70 to -80 ppm.

From the results of FT-IR and ²⁹Si-NMR, this comparative polymer A was identified to be a phenylsiloxazane polymer having on its main chain -(PhSiN3)-, -(PhSiN₂O)-, -(PhSiNO₂)-, and -(PhSiO₃)-. Further, it was found that this polymer A did not have a disilylbenzene structure.

### Synthesis Example 1

Synthesis was carried out in the same manner as in Comparative Synthesis Example 1, except that 105.75 g of phenyltrichlorosilane (PhSiCl₃) and 39.4 g of 1,4-bis(dimethylchlorosilyl)benzene were used as starting materials. As a result, about 63 g of a highly viscous polymer 1 was obtained.

The molecular weight of this polymer 1 was measured. As a result, the number average molecular weight was 1500, and the weight average molecular weight was 4000.

FT-IR of this polymer 1 was measured. As a result, in addition to absorptions observed in polymer A prepared in Comparative Synthesis Example 1, absorption attributable to adjacent hydrogen of a benzene ring was observed around 780 cm⁻¹. The adjacent hydrogen of this benzene ring is derived from 1,4-bis(dimethylchlorosilyl)benzene, that is, a disilylbenzene structure. This results of observation show that 1,4-bis(dimethylchlorosilyl)benzene was introduced into polymer 1. Further, in polymer 1, the content of silicon in the disilylbenzene structure was 37% by mole based on the total number of moles of silicon contained in polymer 1.

### Synthesis Example 2

The air in a reaction vessel installed within a thermostatic chamber was replaced by dry nitrogen. A solution of 47 g of phenyltrichlorosilane (PhSiCl₃), 56 g of diphenyldichlorosilane (Ph₂SiCl₂), 3.8 g of methyldichlorosilane (MeSiHCl₂), and 50 g of 1,4-bis(dimethylchlorosilyl)benzene dissolved in 1000 ml of xylene was then introduced into the reaction vessel. Next, the internal temperature of the reaction vessel was set to -5°C. When the temperature of the solution reached a predetermined temperature, a mixed solution, composed of water and pyridine, prepared by dissolving 13 g of water in 1000 ml of pyridine, was introduced into the reaction vessel at a rate of about 30 ml/min. In this case, upon the introduction of the mixed solution, a reaction of halosilane with water took place, and, consequently, the internal temperatuer of the vessel was raised to -2°C. After the introduction of the mixed solution composed of water and pyridine was completed, the reaction mixture was stirred for one hr. Thereafter, in order to fully react chlorosilane remaining unreacted, ammonia was introduced at a rate of 2NI/min for 30 min, and the reaction mixture was stirred. Upon the introduction of ammonia, the formation of white precipitate of ammonium chloride was observed. After the completion of the reaction, dry nitrogen was blown to remove ammonia remaining unreacted, and solvent displacement was then carried out under nitrogen pressure to give 100 g of polymer 2 which was clear and highly viscous.

The number average molecular weight of polymer 2 thus obtained was 2100. FT-IR of polymer 2 was measured. As a result, absorption attributable to NH group was observed around wavenumber 3350 cm⁻¹: absorption attributable to Si-H was observed around 2160 cm⁻¹; absorption attributable to Si-Ph was observed around 1140 cm⁻¹; absorption attributable to C-H in a benzene ring was observed around 3000 cm⁻¹: absorption attributable to Si-O was observed at 1060 to 1100 cm⁻¹; and absorption attributable to adjacent hydrogen of a benzene ring was observed at 780 cm⁻¹. In polymer 1, the content of silicon in the disilylbenzene structure was 44% by mole based on the total number of moles of silicon contained in polymer 2. The content of carbon in polymer 2 was 55% by weight.

### Synthesis Example 3

Polymer 3 having a disilylbenzene structure was synthesized in the same manner as in Synthesis Example 2, except that 66.3 g of methyltrichlorosilane was used instead of phenyltrichlorosilane and diphenyldichlorosilane. In polymer 3, the content of silicon in the disilylbenzene structure was 28.5% by mole based on the total number of moles of silicon contained in polymer 3. The content of carbon in polymer 3 was 25% by weight.

### Example 1

Polymer A was adjusted in a xylene solvent to a predetermined concentration and was spin coated onto a silicon substrate. The coating film was baked on a hot plate under conditions of 150°C/3 min and was then fired in the air under conditions of 400°C/30 min. Dry etching properties of the film thus obtained were evaluated using an etcher. In this case, in a damascene method, an interlayer insulation film was etched. Gas G1 comprising C₄F₈/N₂/Ar at a mixing ratio of 5/10/100, which is a model gas in the case where processing is stopped at the etching stopper layer, was used as the gas. The total gas flow was 150 SCCM. The evaluation was carried out using an etching apparatus (model NE-N5000, manufactured by ULVAC, Inc.) under conditions of pressure 10 Pa, temperature 20°C, antenna output 500 W, and bias output 250 W.

For each of polymer 1 and polymer 2, likewise, a xylene solution was prepared, the xylene solution was spin coated, and the coating was fired under conditions of 400°C/30 min to form a film. The films thus obtained were evaluated for dry etching properties in the same manner as in polymer A.

Further, methylsilsesquioxane (hereinafter referred to as "MSQ") was provided as an example of a material used in a low-permittivity interlayer insulation film, and silicon nitride (hereinafter referred to as "SiN") and SiO₂ produced from tetraethoxysilane (hereinafter referred to as "TEOS-SiO₂") were provided as an example of a material for the etching stopper layer and were evaluated in the same manner as described above.

The results were as shown in Table 1.

**[Table 1]**

| Table 1 Evaluation of dry etching properties | | |
|---|---|---|
| (Low permittivity film etching conditions) | | |
| Polymer | Etching rate (angstroms/min) | Selectivity* |
| Polymer A | 5000 | 0.9 |
| Polymer 1 | 650 | 7.2 |
| Polymer 2 | 510 | 9.2 |
| MSQ | 4670 | - |
| SiN | 750 | 6.2 |
| TEOS-SiO₂ | 1190 | 3.9 |

| | | |
|---|---|---|
| *Selectivity = (MSQ film etching rate)/(each film etching rate) | | |

Comparison of the results for the films prepared from the above polymers with the results for the MSQ film typical of the low-permittivity interlayer insulation film shows that the films according to the present invention have a significantly low dry etching rate and excellent dry etching resistance. In particular, the etching rate ratio of the MSQ film to the film formed from polymer 2, i.e., selectivity, reaches 9.2.

On the other hand, the selectivity of SiN and TEOS-SiO₂ which are typical materials used as the etching stopper layer are 6.2 and 3.9, respectively. That is, it is apparent that, when a semiconductor device is produced by a damascene method using the composition for formation of etching stopper layer according to the present invention, the etching stopper layer according to the present invention has high dry etching resistance and the selectivity relative to low-permittivity interlayer insulation films such as MSQ is excellent.

The specific permittivity of the film formed from polymer 1 and the specific permittivity of the film formed from polymer 2 were measured and found to be 3.0 and 2.9, respectively. On the other hand, the specific permittivity of SiN prepared by CVD is 8, indicating that the permittivity of the film according to the present invention is very low. Thus, according to the present invention, the permittivity of the etching stopper layer can be lowered, that is, the effective permittivity of the semiconductor device can be lowered.

### Example 2

Dry etching properties of a film of polymer 2, a film of SiN and a film of TEOS-SiO₂ were evaluated in the same manner as in Example 1, except that, in a dual damascene method, SiN and SiO₂ were used as a hard mask, and gas G2 which is a model gas for stopping etching in these layers, that is, C₄F₈/O₂/Ar (mixing ratio = 20/20/100) was used as gas. The results were as shown in Table 2.

[Table 2]

**Table 2 Evaluation of dry etching properties**

| (Conditions for etching stopper layer removal) | |
|---|---|
| Polymer | Etching rate (angstroms/min) |
| Polymer 2 | 5420 |
| SiN | 420 |
| TEOS-SiO₂ | 590 |

Under the above gas conditions, the etching rate of the film formed form polymer 2 is significantly different from the etching rate of SiN or SiO₂, and the selectivity is satisfactory. That is, the film formed using the composition according to the present invention can be selectively removed using SiN or SiO₂ as a hard mask.

### Example 3

Dry etching properties of a film of polymer 2 and an MSQ film were evaluated in the same manner as in Example 1, except that gas G3 comprising C₄F₈/N₂/O₂/Ar at a mixing ratio of 5/10/10/200, which is a model gas in the case where an MSQ film and an etching stopper layer are simultaneously processed, was used as the gas. The results were as shown in Table 3.

[Table 3]

| Table 3 Dry etching properties (Conditions for removal of interlayer insulation film and dry etching film) | |
|---|---|
| Polymer | Etching rate (angstroms/min) |
| Polymer 2 | 2550 |
| MSQ | 2730 |

The above results show that, under the above gas conditions, the etching rate of the film formed from polymer 2 and the etching rate of the MSQ film are similar to each other and thus can be simultaneously processed.

In general, it is difficult that, while the selectivity between the etching stopper layer and the MSQ layer is rendered close to 1, the selectivity between the etching stopper layer and SiN or SiO₂ is rendered large. Also from this point, it is apparent that the composition for formation of etching stopper layer according to the present invention is excellent.

### Example 4

For each of polymer 2 and polymer 3, a film was formed on a substrate in the same manner as in Example 1. For comparison, an SiO₂ film and an SiN film (P-SiN) were provided.

For these films, the etching rate was measured in the same manner as in Example 1, except that the following gas was used.
G4: gas having a CHF₃/O₂/Ar mixing ratio of 20/20/100
G5: gas having a C₄H₈/N₂/Ar mixing ratio of 5/10/100

[Table 4]

**Table 4**

| Type of film | Type of etching as | |
|---|---|---|
| | G4 | G5 |
| SiO2 | 4800 | 700 |
| SiN | 200 | 3400 |
| Polymer 3 | 800 | 1000 |
| Polymer 2 | 50 | 3400 |

| | | |
|---|---|---|
| Unit: angstroms/min | | |

Comparison of the results for polymer 2 having a carbon content of 55% by weight with the results for polymer 3 having a carbon content of 25% by weight show that the film formed from polymer 2 having a high carbon content exhibits an etching rate closer to that of the SiN film, while the selectivity between the film formed from polymer 2 and the SiO₂ film is increased, demonstrating that the use of a suitable etching gas and the use of a polymer having a high carbon content can render the etching rate significantly larger than that of SiO₂ commonly used as a hard mask.

### INDUSTRIAL APPLICABILITY

The present invention may be utilized, for example, in the formation of an etching stopper layer in the production of semiconductor devices. The silicon-containing material for formation of etching stopper layer using the composition according to the present invention can realize excellent etching properties and low permittivity as an etching stopper layer.

## Claims

1. A process for producing a semiconductor device, comprising the steps of: forming an insulating layer and an etching stopper layer on a substrate; removing part of the insulating layer by dry etching; and filling an electrically conductive material into a groove or hole thus formed, wherein said etching stopper layer is formed by curing a composition comprising a silicon-containing polymer, wherein 5% to 100% by mole, based on the total number of moles of silicon contained in the silicon-containing polymer in the composition, of silicon is contained in a disilylbenzene structure, and wherein the silicon containing polymer containing a disilylbenzene structure is a silazane polymer or a siloxazane polymer.

2. The process according to claim 1, wherein the disilylbenzene structure is structure (I) represented by formula 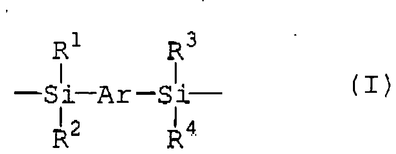 wherein R¹ to R⁴ each independently are selected from a group consisting of hydrogen, an alkyl group, an alkenyl group, a cycloalkyl group, an aryl group, an aralkyl group, an alkylamino group, and an alkylsilyl group, and Ar represents an aryl group.

3. The process according to claim 2, wherein in structure (I) R¹ to R⁴ are independently selected from a group consisting of hydrogen, a C₁ to C₃ alkyl group, a C₂ to C₄ alkenyl group, a C₇ or C₈ cycloalkyl group, a C₆ to C₁₀ aryl group, a C₇ to C₁₁ - aralkyl group, a C₁ to C₃ alkylamino group, a C₁ to C₃ alkyl silyl group, and Ar represents a phenylene group.

4. The process according to claims 2 or 3, wherein the disilylbenzene structure is structure (II) represented by formula 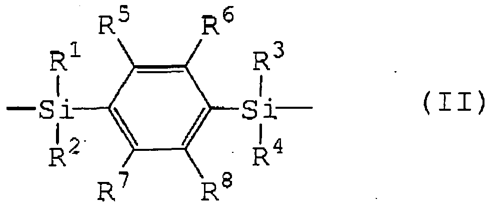 wherein R¹ to R⁴ are as defined in formula (I); and R⁵ to R⁸ are selected from a group consisting of hydrogen, a C₁ to C₃ alkyl group, a halogen atom, a C₁ to C₃ alkoxide group, and a C₁ to C₃ amino group.

5. The process according to any one of the claims 1 to 4, wherein said silicon-containing polymer has been produced by polymerizing a compound having a disilylbenzene structure and an aromatic group-containing compound.

6. A semiconductor device produced according to any one of claims 1 to 5.

7. The use of a composition according to any one of the claims 1 to 5 for forming an etching stopper layer.

## Patentansprüche

1. Verfahren zur Herstellung einer Halbleitervorrichtung, umfassend die Schritte: Bildung einer Isolierschicht und einer Ätzstoppschicht auf einem Substrat; Entfernen eines Teils der Isolierschicht durch Trockenätzen; und Füllen eines elektrisch leitenden Materials in eine dadurch gebildete Rille oder Öffnung, wobei die Ätzstoppschicht gebildet wird durch Härten einer Zusammensetzung, enthaltend ein Silicium enthaltendes Polymer, wobei 5 mol% bis 100 mol% des Siliciums, basierend auf der gesamten Molzahl des Siliciums, das in dem Silicium enthaltenden Polymer in der Zusammensetzung enthalten ist, in einer Disilylbenzolstruktur enthalten ist, und wobei das Silicium enthaltende Polymer, enthaltend eine Disilylbenzolstruktur, ein Silazanpolymer oder ein Siloxazanpolymer ist.

2. Verfahren gemäß Anspruch 1, wobei die Disilylbenzolstruktur eine Struktur der Formel (I) 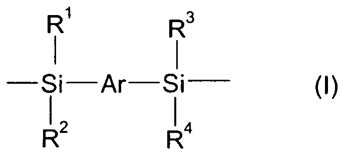 ist, wobei R¹ bis R⁴ jeweils unabhängig voneinander gewählt sind aus einer Gruppe bestehend aus Wasserstoff, einer Alkylgruppe, einer Alkenylgruppe, einer Cycloalkylgruppe, einer Arylgruppe, einer Aralkylgruppe, einer Alkylaminogruppe und einer Alkylsilylgruppe, und wobei Ar eine Arylgruppe darstellt.

3. Verfahren gemäß Anspruch 2, wobei in der Struktur (I) R¹ bis R⁴ unabhängig voneinander gewählt sind aus einer Gruppe bestehend aus Wasserstoff, einer C₁-bis C₃-Alkylgruppe, einer C₂- bis C₄-Alkenylgruppe, einer C₇- oder C₈-Cycloalkylgruppe, einer C₆- bis C₁₀-Arylgruppe, einer C₇- bis C₁₁-Aralkylgruppe, einer C₁- bis C₃-Alkylaminogruppe, einer C₁- bis C₃-Alkylsilylgruppe, und wobei Ar eine Phenylengruppe darstellt.

4. Verfahren gemäß Anspruch 2 oder 3, wobei die Disilylbenzolstruktur eine Struktur der Formel (II) 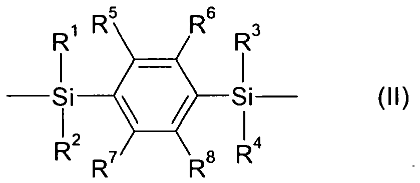 ist, wobei R¹ bis R⁴ wie in der Formel (I) definiert sind; und R⁵ bis R⁸ gewählt sind aus einer Gruppe bestehend aus Wasserstoff, einer C₁- bis C₃-Alkylgruppe, einem Halogenatom, einer C₁- bis C₃-Alkoxidgruppe und einer C₁- bis C₃-Aminogruppe.

5. Verfahren gemäß einem der Ansprüche 1 bis 4, wobei das Silicium enthaltende Polymer hergestellt wurde durch Polymerisieren einer Verbindung mit einer Disilylbenzolstruktur und einer eine aromatische Gruppe enthaltenden Verbindung.

6. Halbleitervorrichtung, hergestellt gemäß einem der Ansprüche 1 bis 5.

7. Verwendung einer Zusammensetzung gemäß einem der Ansprüche 1 bis 5 zur Bildung einer Ätzstoppschicht.

## Revendications

1. Procédé de production d'un dispositif à semi-conducteur, comprenant les étapes suivantes : la formation d'une couche isolante et d'une couche d'arrêt de gravure sur un substrat ; l'élimination d'une partie de la couche isolante par gravure sèche ; et l'introduction d'un matériau électroconducteur dans une rainure ou un trou ainsi formé, ladite couche d'arrêt de gravure étant formée par le durcissement d'une composition comprenant un polymère contenant du silicium, dans lequel 5 % à 100 % en mole, sur la base du nombre total de moles de silicium contenu dans le polymère contenant du silicium dans la composition, du silicium sont contenus dans une structure de disilylbenzène, et dans lequel le polymère contenant du silicium contenant une structure de disilylbenzène est un polymère de silazane ou un polymère de siloxazane.

2. Procédé selon la revendication 1, dans lequel la structure de disilylbenzène est la structure (I) représentée par la formule 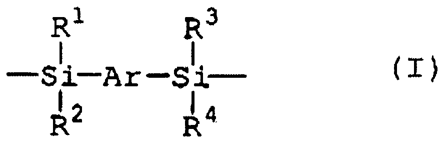 dans laquelle R¹ à R⁴ sont choisis chacun indépendamment dans un groupe constitué d'un hydrogène, un groupe alkyle, un groupe alcényle, un groupe cycloalkyle, un groupe aryle, un groupe aralkyle, un groupe alkylamino et un groupe alkylsilyle, et Ar représente un groupe aryle.

3. Procédé selon la revendication 2, dans lequel, dans la structure (I), R¹ à R⁴ sont choisis indépendamment dans un groupe constitué d'un hydrogène, un groupe alkyle en C₁ à C₃, un groupe alcényle en C₂ à C₄, un groupe cycloalkyle en C₇ ou en C₈, un groupe aryle en C₆ à C₁₀, un groupe aralkyle en C₇ à C₁₁, un groupe alkylamino en C₁ à C₃, un groupe alkylsilyle en C₁ à C₃, et Ar représente un groupe phénylène.

4. Procédé selon la revendication 2 ou 3, dans lequel la structure de disilylbenzène est la structure (II) représentée par la formule 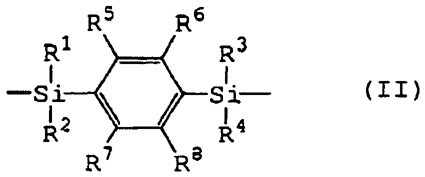 dans laquelle R¹ à R⁴ sont tels que définis dans la formule (I) ; et R⁵ à R⁸ sont choisis dans un groupe constitué d'un hydrogène, un groupe alkyle en C₁ à C₃, un atome d'halogène, un groupe alcoxyde en C₁ à C₃ et un groupe amino en C₁ à C₃.

5. Procédé selon l'une quelconque des revendications 1 à 4, dans lequel le polymère contenant du silicium a été produit par la polymérisation d'un composé possédant une structure de disilylbenzène et d'un composé contenant un groupe aromatique.

6. Dispositif à semi-conducteur produit selon l'une quelconque des revendications 1 à 5.

7. Utilisation d'une composition selon l'une quelconque des revendications 1 à 5 pour former une couche d'arrêt de gravure.
